# FASCICULE DE BREVET EUROPEEN

(11) **EP 1 974 394 B1**
(45) Date de publication et mention de la délivrance du brevet: **28.02.2018**
(21) Numéro de dépôt: 07718282.2
(22) Date de dépôt: 09.01.2007
(51) Int. Cl.: H01L 31/041, H01L 31/042, B64G 1/44, B64G 1/54

(54) **GÉNÉRATEUR SOLAIRE À CONCENTRATEUR D'ARCS ÉLECTRIQUES PRIMAIRES**
SOLARGENERATOR MIT KONZENTRATOR PRIMÄRER LICHTBÖGEN
SOLAR GENERATOR WITH CONCENTRATOR OF PRIMARY ELECTRIC ARCS

(30) Priorité: 20.01.2006 FR 0650212
(43) Date de publication de la demande: 01.10.2008
(73) Titulaire: THALES, 92400 Courbevoie (FR)
(72) Inventeur: BOULANGER, Bernard, 83600 Frejus (FR); BERTHOU, Claude, Cannes La Bocca Cedex, 06156 (FR)
(74) Mandataire: Esselin, Sophie
(86) Numéro de dépôt international: PCT/FR2007/050628
(87) Numéro de publication internationale: WO 2007/083050

(56) Documents cités:
- EP-A- 0 995 676
- WO-A-99/38217
- DE-A1- 3 733 645
- DE-A1- 19 821 368
- FR-A- 2 701 786
- GB-A- 2 224 391
- PATENT ABSTRACTS OF JAPAN vol. 010, no. 032 (E-379), 7 février 1986 (1986-02-07) & JP 60 189272 A (SUMITOMO DENKI KOGYO KK), 26 septembre 1985 (1985-09-26)

## Description

L'invention concerne les générateurs solaires, notamment ceux qui sont embarqués sur des engins spatiaux, comme par exemple des satellites.

Les générateurs solaires comprennent habituellement des cellules photoélectriques raccordées électriquement et revêtues chacune d'une fenêtre (ou écran ou encore filtre) de protection. Ces fenêtres (ou écrans) de protection sont destiné(e)s à protéger les cellules photoélectriques de certains rayonnements, comme par exemple des flux de protons et/ou d'électrons, afin de leur garantir une certaine durée de vie. Par ailleurs, ces fenêtres (ou écrans) de protection devant laisser passer les photons, elles sont généralement réalisées dans un matériau en verre (par exemple de type « coverglass ») et collées à l'aide d'une colle ou d'un adhésif transparent non conducteur électriquement. Ces matériaux n'étant pas conducteurs électriquement, ils ont tendance à se charger de façon électrostatique, ce qui provoque parfois localement un arc électrique dit primaire (ou décharge électrostatique (ESD)) entre sa fenêtre de protection et la cellule photoélectrique qu'il recouvre ou une cellule photoélectrique voisine.

Le terme fenêtre de protection désigne ici l'ensemble constitué par le matériau de protection de la cellule (par exemple le coverglass) et sa colle ou son adhésif.

Comme le sait l'homme de l'art, cet arc électrique primaire est constitué de deux parties.

La première partie est connue sous le terme anglais « blow-off ». Elle se présente sous la forme d'un courant induit par la décharge rapide de la capacité générale de l'équipement (par exemple un satellite) sur lequel est installé le générateur solaire.

La seconde partie est connue sous le terme anglais « flash-over ». Elle se présente sous la forme d'un courant induit par la décharge lente des fenêtres de protection de certaines au moins des cellules photoélectriques, selon un mécanisme de propagation de proche en proche dont la vitesse est de l'ordre de 10⁴ m/s. Ce mécanisme de propagation se fait des fenêtres de protection, des cellules qui sont montées en série de manière à constituer une branche, vers la fenêtre de protection de la cellule qui est l'objet de l'arc électrique primaire, du fait du plasma qui se crée entre les fenêtres de protection des cellules voisines. Il se fait également des fenêtres de protection des cellules, qui font partie de branches voisines de la branche contenant la cellule objet de l'arc électrique primaire, vers la fenêtre de protection de cette dernière cellule, du fait du plasma et de la circulation du courant de décharge lente de la branche objet de l'arc électrique primaire vers les branches voisines, via leurs liaisons électriques. La circulation du courant de décharge lente se fait généralement via les extrémités des branches qui sont de polarité négative, étant donné que leurs extrémités opposées, de polarité positive, sont généralement pourvues de moyens de blocage de courant, tels que des diodes.

Ce flash-over (ou décharge lente) peut entraîner une dégradation de certaines cellules photoélectriques lorsque sa durée dépasse un seuil qui dépend du matériau dans lequel elles sont réalisées. C'est notamment le cas lorsque les cellules photoélectriques sont réalisées dans un matériau semiconducteur tel que l'Arséniure de Gallium (ou AsGa) et que la durée du flash-over (ou décharge lente) est supérieure à environ 100 µs. Cette dégradation entraîne une diminution de la durée de vie des cellules photoélectriques (et donc une réduction de leur fiabilité), ce qui est particulièrement ennuyeux lorsqu'elles ne peuvent pas être remplacées.

Le document EP0995676 décrit un générateur solaire pour un équipement spatial comprenant une surface rendue électriquement conductrice pour dissiper les charges électrostatiques. Le document FR2701786 décrit une cellule photovoltaïque comportant un dispositif d'évacuation des charges électrostatiques avec une grille en matériau conducteur transparent sur la surface externe de la lame de verre de protection de la cellule.

L'invention a donc pour but de remédier au moins partiellement à l'inconvénient précité. Elle propose à cet effet un générateur solaire selon la revendication 1, pour un équipement comportant une référence électrique, et comprenant une zone pourvue d'au moins deux cellules photoélectriques, raccordées électriquement et revêtues chacune d'une fenêtre de protection pouvant se charger de façon électrostatique.

Ce générateur solaire se caractérise par le fait qu'il comprend :
- en au moins un endroit choisi de la zone, des moyens d'intensification chargés d'intensifier localement la charge électrostatique, afin de forcer la génération d'arcs électriques primaires en cet endroit choisi, et
- des moyens de décharge destinés à coupler les moyens d'intensification à la référence électrique de l'équipement afin d'évacuer vers cette référence électrique des courants de décharge induits par les arcs électriques primaires.

Les moyens d'intensification agissent ainsi d'une façon similaire à un « paratonnerre » en localisant les arcs électriques primaires en un endroit choisi afin que les courants de décharge qu'induisent ces derniers puissent être évacués par les moyens de décharge sans dégrader les cellules photoélectriques du réseau actif du générateur solaire.

Le générateur solaire selon l'invention peut comporter d'autres caractéristiques qui peuvent être prises séparément ou en combinaison, et notamment :
- ses moyens d'intensification peuvent être constitués par au moins une fenêtre de protection constituée d'un ensemble associant un matériau de protection diélectrique collé par des moyens d'adhésion (colle ou adhésif) isolant électriquement ;
   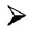 chaque fenêtre de protection des moyens d'intensification peut par exemple être réalisée dans un matériau présentant des propriétés diélectriques différentes de celles du matériau dans lequel est réalisée une partie au moins des fenêtres de protection des cellules photoélectriques. Ce matériau peut par exemple être plus isolant électriquement et/ou présenter des propriétés d'émission secondaire plus importantes ;
   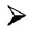 dans une première variante, chaque fenêtre de protection des moyens d'intensification peut par exemple être réalisée dans un matériau de protection identique au matériau de protection dans lequel sont réalisées les fenêtres de protection des cellules photoélectriques (par exemple en coverglass). Dans ce cas, l'épaisseur de chaque matériau de protection des moyens d'intensification est choisie strictement supérieure à l'épaisseur des matériaux de protection des cellules photoélectriques ;
   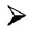 dans une deuxième variante, chaque fenêtre de protection des moyens d'intensification peut par exemple être réalisée dans un matériau de protection (identique ou non à celui utilisé habituellement pour les fenêtres de protection) et associé à une colle ou un adhésif présentant une épaisseur supérieure à celle habituellement utilisée pour les fenêtres de protection ou bien associé à une colle ou un adhésif ayant une résistivité électrique supérieure ;
   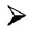 dans une troisième variante, chaque fenêtre de protection des moyens d'intensification peut inclure un métal flottant électriquement, laissé exposé au vide de manière à former un point triple « métal-vide-diélectrique » propice à l'apparition d'une décharge électrostatique. Ce métal flottant peut, par exemple, se situer sur la face interne du matériau de protection, voire sur sa face externe, ou bien se situer sur l'adhésif ou la colle ;
- il peut comprendre plusieurs panneaux comportant chacun plusieurs cellules photoélectriques et raccordés électriquement les uns aux autres. Dans ce cas, les moyens d'intensification sont implantés dans au moins un endroit choisi d'au moins l'un des panneaux ;
   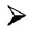 les moyens d'intensification peuvent être implantés dans au moins un endroit choisi situé sur le panneau qui est destiné à être le plus éloigné de la structure de support de l'équipement ;
- ses moyens de décharge comprennent une électrode située au voisinage des moyens d'intensification, et une ligne de masse connectée à l'électrode et destinée à être couplée à la référence électrique de l'équipement ;
   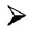 la ligne de masse peut être couplée à des moyens de mesure chargés de mesurer les intensités et/ou les durées et/ou les dates de création et/ou les fréquences de création des courants de décharge ;
   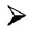 il peut comprendre des moyens d'isolation chargés d'isoler électriquement la ligne de masse du reste du générateur solaire ;
   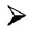 l'électrode peut par exemple être constituée d'une plaque conductrice comprenant une partie centrale et une partie périphérique solidarisée aux moyens d'intensification ;
   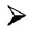 en variante, l'électrode peut par exemple être une cellule photoélectrique solidarisée à une face arrière des moyens d'intensification et déconnectée électriquement des autres cellules photoélectriques ;
- ses cellules photoélectriques peuvent être réalisées en matériau semiconducteur, et par exemple en Arséniure de Gallium (AsGa).

L'invention est particulièrement bien adaptée, bien que de façon non exclusive, aux engins spatiaux, et notamment aux satellites.

D'autres caractéristiques et avantages de l'invention apparaîtront à l'examen de la description détaillée ci-après, et des dessins annexés, sur lesquels :
- la figure 1 illustre de façon très schématique et fonctionnelle un exemple de réalisation d'un générateur solaire selon l'invention solidarisé à la structure d'un équipement,
- la figure 2 illustre de façon très schématique et fonctionnelle une représentation sous la forme d'un circuit de masse de l'exemple de générateur solaire illustré sur la figure 1,
- les figures 3A et 3B illustrent de façon très schématique respectivement une vue en coupe et une vue du dessus d'un exemple de réalisation d'ensemble électrode de décharge/moyen d'intensification.

Les dessins annexés pourront non seulement servir à compléter l'invention, mais aussi contribuer à sa définition, le cas échéant.

L'invention a pour objet de permettre la concentration des arcs électriques dits primaires (ou décharges électrostatiques (ESDs)) induits par l'accumulation de charges électrostatiques sur les fenêtres de protection des cellules photoélectriques des générateurs solaires, du fait qu'elles sont réalisées dans un matériau non conducteur électriquement.

Dans ce qui suit, on considère à titre d'exemple non limitatif que le générateur solaire est destiné à être implanté sur un engin spatial, comme par exemple un satellite. Mais, l'invention n'est pas limitée à cette application. Elle concerne en effet tout type d'équipement ou système comportant une référence électrique et au moins un générateur solaire (c'est-à-dire un équipement présentant des tensions actives différentielles exposées au vide, à l'image d'une antenne active) susceptible d'être le siège d'arcs électriques primaires.

Par ailleurs, l'invention s'applique dès lors que le générateur solaire comprend au moins une zone dans laquelle sont implantées au moins deux cellules photoélectriques, raccordées électriquement et revêtues chacune d'une fenêtre de protection pouvant se charger de façon électrostatique.

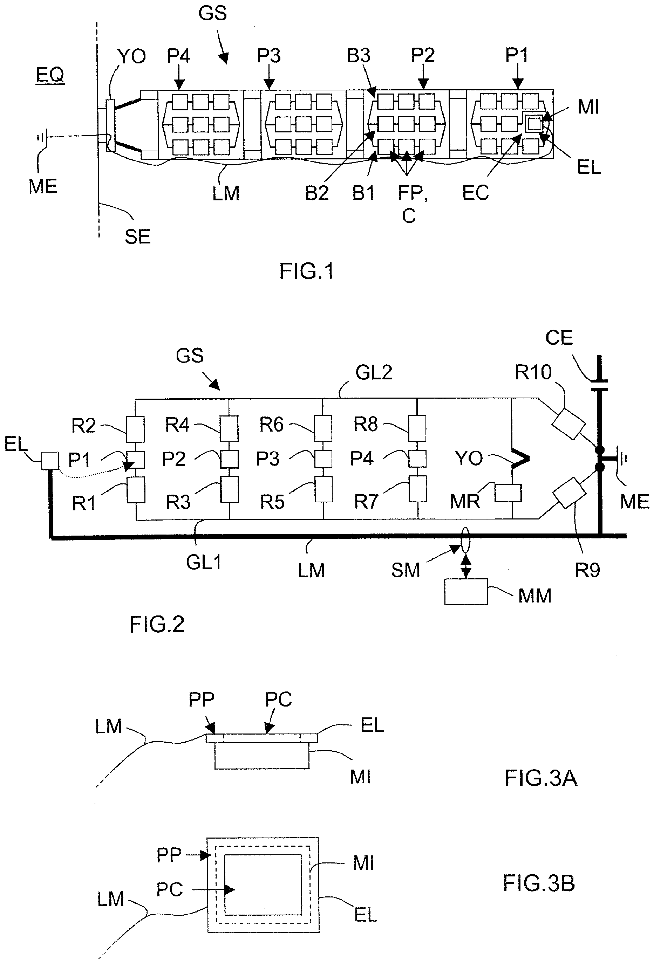

Dans l'exemple non limitatif illustré sur la figure 1, le générateur solaire GS comprend quatre panneaux Pi (i = 1 à 4) raccordés mécaniquement et électriquement les uns aux autres. L'un des panneaux, ici P4, est connecté à la structure SE de l'engin (ou équipement) EQ, par l'intermédiaire d'un support articulé YO, plus connu sous le nom anglais « yoke ».

Chaque panneau Pi comprend un ensemble d'au moins deux cellules photoélectriques C connectées électriquement, en série ou en parallèle. Les ensembles des différents panneaux Pi sont généralement connectés électriquement les uns aux autres. Dans l'exemple illustré sur le schéma de masse de la figure 2, les ensembles de cellules photoélectriques C sont connectés à la référence électrique ME de l'engin. De plus, chaque panneau Pi est raccordé à deux lignes électriques de masse (ou « grounding lines ») GL1 et GL2 par l'intermédiaire de deux résistances (R1 et R2 pour le panneau P1, R3 et R4 pour le panneau P2, R5 et R6 pour le panneau P3, et R7 et R8 pour le panneau P4). Le support articulé (ou yoke) YO et le moteur MR d'entraînement des panneaux Pi sont montés en série et raccordés aux deux lignes électriques de masse GL1 et GL2. Par ailleurs, les deux lignes électriques de masse GL1 et GL2 sont connectées à la référence électrique ME de l'engin EQ par l'intermédiaire de résistances R9 et R10, respectivement. Cette référence électrique ME est par exemple le zéro volt (0 V) du bus de commande de l'engin EQ.

Enfin, sur le schéma de masse de la figure 2, le condensateur CE, raccordé à la référence électrique ME de l'engin EQ, représente la capacité électrique de ce dernier.

Dans l'exemple non limitatif illustré sur la figure 1, chaque ensemble de cellules photoélectriques C comprend trois branches B1 à B3 montées électriquement en parallèle et comportant au moins deux cellules photoélectriques C connectées électriquement les unes aux autres en série. Bien entendu, ce type d'assemblage n'est qu'un exemple. Toute combinaison d'au moins deux cellules photoélectriques C peut en effet constituer un ensemble de cellules photoélectriques C implanté dans une zone d'un panneau Pi.

Chaque cellule photoélectrique C active, c'est-à-dire contribuant à la génération de courant électrique au sein d'un générateur solaire GS, peut être réalisée dans un matériau semiconducteur. Par exemple, elles sont de type « Arséniure de Gallium (AsGa) ». Dans ce cas, elle peuvent être de type simple jonction ou de type multijonction. Mais, les cellules photoélectriques pourraient être également de type « Silicium ».

Par ailleurs, chaque cellule photoélectrique active C comporte une face avant recouverte d'une fenêtre (ou écran) de protection FP (par exemple de type « coverglass »). L'invention concerne tout type de fenêtre (ou écran) de protection FP susceptible d'être le siège d'une accumulation de charges électrostatiques et donc d'arcs électriques dits primaires (ou décharges électrostatiques (ESDs)), selon la définition donnée dans la partie introductive.

Comme évoqué précédemment, l'invention propose de concentrer en au moins un endroit choisi EC, de la zone comportant les cellules photoélectriques actives C, les arcs électriques primaires qui sont induits par l'accumulation de charges électrostatiques sur les fenêtres de protection FP de ces cellules photoélectriques actives C.

Plus précisément, l'invention propose tout d'abord d'implanter des moyens d'intensification MI chargés d'intensifier localement la charge électrostatique, dans au moins un endroit choisi EC de la zone comportant les cellules photoélectriques actives C de l'un au moins des générateurs solaires GS d'un équipement (ou engin ou système) EQ, afin de forcer la génération d'arcs électriques primaires en cet endroit choisi EC. L'invention propose également de coupler les moyens d'intensification MI à la référence électrique ME de l'engin EQ par l'intermédiaire de moyens de décharge EL et LM, afin d'évacuer vers cette référence électrique ME les courants de décharge qui sont induits par les arcs électriques primaires générés localement du fait de la présence des moyens d'intensification MI.

Il ne s'agit donc pas de supprimer les arcs électriques primaires, mais de créer, en au moins un endroit choisi EC de la zone comportant les cellules photoélectriques actives C, des conditions diélectriques locales forçant la génération des arcs électriques primaires, si possible la quasi totalité d'entre eux. En d'autres termes, on constitue localement en chaque endroit choisi une espèce de « paratonnerre » chargé de concentrer la génération des arcs électriques primaires afin que les courants de décharge qu'ils induisent soient évacués par les moyens de décharge EL et LM. Les arcs électriques primaires ne survenant plus (ou quasiment plus) au niveau des cellules photoélectriques actives C, ils ne dégradent donc plus ces dernières.

Lorsque le générateur solaire GS comprend plusieurs panneaux Pi, les moyens d'intensification MI sont de préférence implantés dans au moins un endroit choisi situé sur le panneau Pi qui est susceptible de se charger le plus. Par exemple, lorsque le générateur solaire GS équipe un engin spatial EQ, tel qu'un satellite, on implante de préférence des moyens d'intensification MI sur le panneau P1 qui est le plus éloigné de la structure de support SE de cet engin spatial EQ, comme cela est illustré sur les figures 1 et 2.

Les moyens d'intensification MI sont préférentiellement réalisés sous la forme d'au moins une fenêtre de protection. Celle-ci peut être réalisée dans le même matériau de protection que celui habituellement utilisé pour les fenêtres de protection FP des cellules photoélectriques actives C (par exemple en coverglass). Dans ce cas, et afin de créer les conditions diélectriques propices à la concentration locale des arcs électriques primaires, chaque fenêtre de protection des moyens d'intensification MI présente une épaisseur choisie, strictement supérieure à l'épaisseur des fenêtres de protection FP des cellules photoélectriques actives C. Par exemple, si l'on utilise des fenêtres de protection FP en coverglass d'une épaisseur de 100 à 150 µm, chaque fenêtre de protection des moyens d'intensification MI peut présenter une épaisseur supérieure à 150 ou 200 µm, par exemple 300 ou 500 µm.

On peut aussi envisager d'augmenter l'épaisseur de la colle ou de l'adhésif sous le matériau de protection, par rapport à l'épaisseur habituellement utilisée pour les fenêtres de protection.

On peut également associer au matériau de protection un métal flottant électriquement, exposé au vide, afin de créer des conditions dites de point triple « métal-vide-diélectrique » favorables à l'apparition de décharges électriques. Ce métal flottant peut, par exemple, se situer sur la face interne du matériau de protection, voire sur sa face externe, ou bien se situer sur l'adhésif ou la colle.

Certains équipements de satellite, autres que des générateurs solaires, comme par exemple des antennes actives, présentent en exposition directe de l'espace de tels points triples « métal-vide-diélectrique » avec présence de tensions actives, c'est-à-dire de tensions positivement ou négativement directement référencées au système de génération ou de conditionnement de puissance du satellite. Ces équipements (par exemple des antennes actives) peuvent donc être protégés des décharges en concentrant ces dernières au niveau de moyens d'intensification selon l'invention.

Mais, on peut également envisager que chaque fenêtre de protection des moyens d'intensification MI soit réalisée dans des matériaux de protection (diélectriques) différents de ceux utilisés pour les fenêtres de protection FP des cellules photoélectriques actives C (par exemple coverglass et/ou colle (ou adhésif)). Dans ce cas, les matériaux diélectriques de chaque fenêtre de protection des moyens d'intensification MI doivent être notablement plus isolants électriquement et/ou présenter une émission secondaire plus grande que ceux des fenêtres de protection FP des cellules photoélectriques actives C.

On notera que les moyens d'intensification MI peuvent être constitués de plusieurs (au moins deux) fenêtres de protection voisines, et de préférence proches l'une de l'autre.

Les moyens de décharge EL, LM comprennent une électrode EL, située au voisinage des moyens d'intensification MI, ainsi qu'une ligne de masse LM connectée à l'électrode EL et (destinée à être) couplée à la référence électrique ME de l'engin EQ.

La ligne de masse LM est un câble électrique qui comporte de préférence une isolation, si possible double, afin d'être parfaitement isolée électriquement du reste du générateur solaire GS. Cette (double) isolation est par exemple obtenue par (double) gainage.

Afin de contrôler les courants de décharge (induits par les arcs électriques primaires) qui sont évacués par la ligne de masse LM, on peut coupler cette dernière à des moyens de mesure. Par exemple, les moyens de mesure peuvent comporter une sonde de mesure SM couplée à la ligne de masse LM et un module de mesure MM couplé à la sonde de mesure SM et chargé de détecter les formes d'onde des courants de décharge. Grâce à ces formes d'onde, le module de mesure MM peut mesurer les intensités et/ou les durées et/ou les dates de création et/ou les fréquences de création des courants de décharge, et stocker ces informations dans une mémoire en vue d'une analyse ultérieure, éventuellement dans une station terrestre après transfert par voie d'ondes.

Comme cela est schématiquement illustré sur les figures 3A et 3B, l'électrode EL peut par exemple être constituée d'une plaque conductrice comprenant une partie centrale PC (éventuellement évidée) et une partie périphérique PP solidarisée aux moyens d'intensification MI et connectée à la ligne de masse LM. Par exemple, la partie périphérique PP de la plaque conductrice EL est collée sur la face avant (orientée vers l'espace) de la fenêtre de protection des moyens d'intensification MI.

La plaque conductrice EL peut par exemple être réalisé dans un matériau conducteur tel que l'aluminium ou l'argent.

Au lieu d'être réalisée sous la forme d'une plaque conductrice, l'électrode EL peut par exemple être l'une des cellules photoélectriques implantée sur un panneau Pi. Bien entendu, dans ce cas, on utilise comme électrode une cellule photoélectrique qui n'est pas active, c'est-à-dire qui est déconnectée électriquement des cellules photoélectriques actives C et donc qui ne contribue pas à la génération de courant.

Dans ce cas, la cellule photoélectrique inactive servant d'électrode EL comprend une face avant (opposée au panneau Pi) solidarisée (par exemple par collage) à la face arrière de la fenêtre de protection constituant tout ou partie des moyens d'intensification MI. Par ailleurs, cette cellule photoélectrique inactive EL est désormais connectée à la ligne de masse LM au lieu d'être connectée électriquement à l'ensemble de cellules photoélectriques actives C implanté sur son panneau Pi.

Lorsqu'un équipement EQ comporte plusieurs générateurs solaires, il n'est pas obligatoire que chacun d'entre eux soit du type décrit ci-avant (c'est-à-dire pourvu de moyens d'intensification MI et de moyens de décharge EL et LM). Ce qui est important c'est que l'un au moins de ses générateurs solaires soit conforme à l'invention, le ou les autres pouvant être soit conforme à l'invention, soit de type classique (c'est-à-dire dépourvu de moyens d'intensification MI et de moyens de décharge EL et LM). Le nombre de générateurs solaires GS conformes à l'invention au sein d'un équipement EQ et le nombre d'endroits choisis et leurs positions respectives au sein de chaque générateur solaire GS conforme à l'invention dépendent de la mission de cet équipement EQ, et des conditions d'utilisation (positionnements et environnements) de chacun de ses générateurs solaires.

L'invention offre un certain nombre d'avantages, et notamment :
- elle permet de fiabiliser la puissance délivrée par les cellules photoélectriques actives,
- elle évite de faire des études statistiques préliminaires relatives à l'impact des arcs électriques primaires sur les pertes de puissance des cellules photoélectriques actives,
- elle évite de faire des essais préliminaires de caractérisation de dégradation des cellules photoélectriques actives en fonction des arcs électriques primaires,
- elle permet de limiter les essais de qualification ESD à la tenue dans un plasma dense (ionosphère ou plasma issu de propulseurs électriques).

L'invention ne se limite pas aux modes de réalisation de générateur solaire GS et d'équipement EQ décrits ci-avant, seulement à titre d'exemple, mais elle englobe toutes les variantes que pourra envisager l'homme de l'art dans le cadre des revendications ci-après.

## Revendications

1. Générateur solaire (GS), pour un équipement (EQ) comportant une référence électrique (ME), et comprenant une zone pourvue d'au moins deux cellules photoélectriques (C), raccordées électriquement et revêtues chacune d'une fenêtre de protection (FP) pouvant se charger de façon électrostatique, **caractérisé en ce qu'**il comprend
i) en au moins un endroit choisi (EC) de ladite zone, des moyens d'intensification (MI) configurés de manière à créer des conditions diélectriques locales propres à intensifier localement la charge électrostatique, de manière à forcer la génération d'arcs électriques primaires en cet endroit choisi (EC), et
ii) des moyens de décharge (EL, LM) propres à coupler lesdits moyens d'intensification (MI) à ladite référence électrique (ME) dudit équipement (EQ) de manière à évacuer vers cette référence électrique (ME) des courants de décharge induits par lesdits arcs électriques primaires, lesdits moyens de décharge comprenant une électrode (EL) située au voisinage desdits moyens d'intensification (MI) et une ligne de masse (LM) connectée à ladite électrode et destinée à être couplée à la référence électrique (ME) dudit équipement.

2. Générateur solaire selon la revendication 1, **caractérisé en ce que** lesdits moyens d'intensification (MI) sont réalisés sous la forme d' au moins une fenêtre de protection constituée d'un ensemble associant un matériau de protection diélectrique collé par des moyens d'adhésion isolants électriquement.

3. Générateur solaire selon la revendication 2, **caractérisé en ce que** chaque fenêtre de protection desdits moyens d'intensification (MI) est réalisée dans un matériau présentant des propriétés diélectriques différentes de celles du matériau dans lequel est réalisée au moins une partie desdites fenêtres de protection (FP) desdites cellules photoélectriques (C).

4. Générateur solaire selon la revendication 2, **caractérisé en ce que** chaque fenêtre de protection desdits moyens d'intensification (MI) est réalisée dans un matériau de protection identique au matériau de protection dans lequel sont réalisées les fenêtres de protection (FP) desdites cellules photoélectriques (C), et **en ce que** l'épaisseur du matériau de protection de chaque fenêtre de protection desdits moyens d'intensification (MI) est choisie strictement supérieure à l'épaisseur du matériau de protection des fenêtres de protection (FP) desdites cellules photoélectriques (C).

5. Générateur solaire selon la revendication 2, **caractérisé en ce que** chaque fenêtre de protection desdits moyens d'intensification (MI) est réalisée dans un matériau de protection identique au matériau de protection dans lequel sont réalisées les fenêtres de protection (FP) desdites cellules photoélectriques (C), et **en ce que** l'épaisseur desdits moyens d'adhésion de chaque fenêtre de protection desdits moyens d'intensification (MI) est choisie strictement supérieure à l'épaisseur desdits moyens d'adhésion des fenêtres de protection (FP) desdites cellules photoélectriques (C).

6. Générateur solaire selon la revendication 2, **caractérisé en ce que** chaque fenêtre de protection desdits moyens d'intensification (MI) comprend un métal flottant électriquement, laissé exposé au vide de manière à former un point triple propre à faire apparaître une décharge électrostatique.

7. Générateur solaire selon l'une des revendications 1 à 6, **caractérisé en ce qu'**il comprend plusieurs panneaux (Pi) comportant chacun plusieurs cellules photoélectriques et raccordés électriquement les uns aux autres, et **en ce que** lesdits moyens d'intensification (MI) sont implantés dans au moins un endroit choisi (EC) d'au moins l'un desdits panneaux (Pi).

8. Générateur solaire selon la revendication 7, **caractérisé en ce que** lesdits moyens d'intensification (MI) sont implantés dans au moins un endroit choisi (EC) situé sur le panneau (P1) destiné à être le plus éloigné d'une structure de support (SE) dudit équipement (EQ).

9. Générateur solaire selon l'une des revendications 1 à 8, **caractérisé en ce que** ladite ligne de masse (LM) est couplée à des moyens de mesure (SM, MM) agencés pour mesurer les intensités et/ou les durées et/ou les dates de création et/ou les fréquences de création desdits courants de décharge.

10. Générateur solaire selon l'une des revendications 1 à 9, **caractérisé en ce qu'**il comprend des moyens d'isolation agencés pour isoler électriquement ladite ligne de masse (LM) du reste dudit générateur solaire (GS).

11. Générateur solaire selon la revendication 10, **caractérisé en ce que** lesdits moyens d'isolation sont agencés pour assurer une double isolation.

12. Générateur solaire selon l'une des revendications 1 à 11, **caractérisé en ce que** ladite électrode (EL) est constituée d'une plaque conductrice comprenant une partie centrale (PC) et une partie périphérique (PP) solidarisée auxdits moyens d'intensification (MI).

13. Générateur solaire selon l'une des revendications 1 à 11, **caractérisé en ce que** ladite électrode (EL) est une cellule photoélectrique solidarisée à une face arrière desdits moyens d'intensification (MI) et déconnectée électriquement des autres cellules photoélectriques (C).

14. Générateur solaire selon l'une des revendications 1 à 13, **caractérisé en ce que** lesdites cellules photoélectriques (C) sont réalisées en matériau semiconducteur.

15. Générateur solaire selon la revendication 14, **caractérisé en ce que** le matériau semiconducteur est l' « Arséniure de Gallium » (AsGa).

16. Générateur solaire selon la revendication 15, **caractérisé en ce que** lesdites cellules photoélectriques (C) sont de type multijonction.

17. Engin spatial, **caractérisé en ce qu'**il comprend au moins un générateur solaire (GS) selon l'une des revendications précédentes.

18. Engin spatial selon la revendication 17, **caractérisé en ce qu'**il comprend plusieurs générateurs solaires dont au moins un est dépourvu de moyens d'intensification (MI) et de moyens de décharge (EL, LM).

## Patentansprüche

1. Solargenerator (GS) für eine Anlage (EQ) mit einer elektrischen Referenz (ME) und aufweisend einen Bereich, der mit mindestens zwei fotoelektrischen Zellen (C) versehen ist, die elektrisch verbunden und jeweils mit einem Schutzfenster (FP) beschichtet sind, das sich elektrostatisch aufladen kann, **dadurch gekennzeichnet, dass** er aufweist
i) Verstärkungsmittel (MI), an mindestens einer ausgewählten Stelle (EC) des Bereichs, die so ausgelegt sind, dass sie dielektrische lokale Bedingungen schaffen, die geeignet sind, die elektrostatische Ladung lokal zu verstärken, sodass die Erzeugung von primären Lichtbögen an dieser ausgewählten Stelle (EC) erzwungen wird, und
ii) Entlademittel (EL, LM), die geeignet sind, die Verstärkungsmittel (MI) mit der elektrischen Referenz (ME) der Anlage (EQ) so zu verbinden, dass die durch die primären Lichtbögen induzierten Entladeströme zu dieser elektrischen Referenz (ME) abgeführt werden, wobei die Entlademittel eine Elektrode (EL) aufweisen, die sich in der Nähe der Verstärkungsmittel (MI) befindet, und eine Masseleitung (LM), die an die Elektrode angeschlossen und dazu bestimmt ist, mit der elektrischen Referenz (ME) der Anlage verbunden zu werden.

2. Solargenerator nach Anspruch 1, **dadurch gekennzeichnet, dass** die Verstärkungsmittel (MI) in der Form von mindestens einem Schutzfenster ausgebildet sind, das durch einen Verbund gebildet ist, der ein dielektrisches, mit elektrisch isolierenden Haftmitteln verklebtes Schutzmaterial verbindet.

3. Solargenerator nach Anspruch 2, **dadurch gekennzeichnet, dass** jedes Schutzfenster der Verstärkungsmittel (MI) aus einem Material ausgebildet ist, das dielektrische Eigenschaften aufweist, die von denjenigen des Materials verschieden sind, aus dem mindestens ein Teil der Schutzfenster (FP) der fotoelektrischen Zellen (C) ausgebildet ist.

4. Solargenerator nach Anspruch 2, **dadurch gekennzeichnet, dass** jedes Schutzfenster der Verstärkungsmittel (MI) aus einem Schutzmaterial ausgebildet ist, das mit dem Schutzmaterial identisch ist, aus dem die Schutzfenster (FP) der fotoelektrischen Zellen (C) ausgebildet sind, und dadurch, dass die Dicke des Schutzmaterials jedes Schutzfensters der Verstärkungsmittel (MI) strikt größer als die Dicke des Schutzmaterials der Schutzfenster (FP) der fotoelektrischen Zellen (C) ausgewählt wird.

5. Solargenerator nach Anspruch 2, **dadurch gekennzeichnet, dass** jedes Schutzfenster der Verstärkungsmittel (MI) aus einem Schutzmaterial ausgebildet ist, das mit dem Schutzmaterial identisch ist, aus dem die Schutzfenster (FP) der fotoelektrischen Zellen (C) ausgebildet sind, und dadurch, dass die Dicke der Haftmittel jedes Schutzfensters der Verstärkungsmittel (MI) strikt größer als die Dicke der Haftmittel der Schutzfenster (FP) der fotoelektrischen Zellen (C) ausgewählt wird.

6. Solargenerator nach Anspruch 2, **dadurch gekennzeichnet, dass** jedes Schutzfenster der Verstärkungsmittel (MI) ein elektrisch schwebendes Metall aufweist, das dem Vakuum ausgesetzt gelassen wird, um einen Tripelpunkt auszubilden, der geeignet ist, eine elektrostatische Entladung hervorzubringen.

7. Solargenerator nach einem der Ansprüche 1 bis 6, **dadurch gekennzeichnet, dass** er mehrere Schilde (Pi) aufweist, die jeweils mehrere fotoelektrische Zellen enthalten und miteinander elektrisch verbunden sind, und dadurch, dass die Verstärkungsmittel (MI) in mindestens eine ausgewählte Stelle (EC) von mindestens einem der Schilde (Pi) eingesetzt sind.

8. Solargenerator nach Anspruch 7, **dadurch gekennzeichnet, dass** die Verstärkungsmittel (MI) in mindestens eine ausgewählte Stelle (EC) eingesetzt sind, die sich auf dem Schild (P1) befindet, das dazu bestimmt ist, das am weitesten entfernte von einer Trägerstruktur (SE) der Anlage (EQ) zu sein.

9. Solargenerator nach einem der Ansprüche 1 bis 8, **dadurch gekennzeichnet, dass** die Masseleitung (LM) mit Messmitteln (SM, MM) verbunden ist, die angeordnet sind, um die Stärken und/oder die Zeiträume und/oder die Entstehungsdatumsangaben und/oder die Entstehungshäufigkeiten der Entladungsströme zu messen.

10. Solargenerator nach einem der Ansprüche 1 bis 9, **dadurch gekennzeichnet, dass** er Isoliermittel aufweist, die angeordnet sind, um die Masseleitung (LM) von dem Rest des Solargenerators (GS) elektrisch zu isolieren.

11. Solargenerator nach Anspruch 10, **dadurch gekennzeichnet, dass** die Isoliermittel zum Sicherstellen einer doppelten Isolierung angeordnet sind.

12. Solargenerator nach einem der Ansprüche 1 bis 11, **dadurch gekennzeichnet, dass** die Elektrode (EL) aus einer Leiterplatte gebildet ist, die einen Mittelteil (PC) und einen Umfangsteil (PP) aufweist, der fest mit den Verstärkungsmitteln (MI) verbunden ist.

13. Solargenerator nach einem der Ansprüche 1 bis 11, **dadurch gekennzeichnet, dass** die Elektrode (EL) eine fotoelektrische Zelle ist, die mit einer Rückseite der Verstärkungsmittel (MI) fest verbunden ist und elektrisch von den anderen fotoelektrischen Zellen (C) abgekoppelt ist.

14. Solargenerator nach einem der Ansprüche 1 bis 13, **dadurch gekennzeichnet, dass** die fotoelektrischen Zellen (C) aus einem Halbleitermaterial ausgebildet sind.

15. Solargenerator nach Anspruch 14, **dadurch gekennzeichnet, dass** das Halbleitermaterial "Galliumarsenid" (AsGa) ist.

16. Solargenerator nach Anspruch 15, **dadurch gekennzeichnet, dass** die fotoelektrischen Zellen (C) vom Typ "Mehrfachanschluss" sind.

17. Raumfahrzeug, **dadurch gekennzeichnet, dass** es mindestens einen Solargenerator (GS) nach einem der vorhergehenden Ansprüche aufweist.

18. Raumfahrzeug nach Anspruch 17, **dadurch gekennzeichnet, dass** es mehrere Solargeneratoren aufweist, von denen mindestens einer frei von Verstärkungsmitteln (MI) und Entlademitteln (EL, LM) ist.

## Claims

1. A solar generator (GS) for equipment (EQ) including an electrical reference (ME) and comprising an area provided with at least two photoelectric cells (C) connected electrically and each covered by a protective window (FP) that can be electrostatically charged, **characterised in that** it comprises
i) in at least one chosen location (EC) of said area, intensification means (MI) configured such as to create local dielectric conditions conducive to intensifying locally the electrostatic charge so as to force the generation of primary electrical arcs at this chosen location (EC), and
ii) discharging means (EL, LM) conducive to coupling said intensification means (MI) to said electrical reference (ME) of said equipment (EQ) so as to evacuate to this electrical reference (ME) discharge currents induced by said primary electrical arcs, said discharge means comprising an electrode (EL) located in the vicinity of said intensification means (MI) and a grounding line (LM) connected to said electrode and intended to be coupled to the electrical reference (ME) of said equipment.

2. The solar generator according to claim 1, **characterised in that** said intensification means (MI) are produced in the form of at least one protective window formed by an assembly associating a dielectric protective material stuck by electrically insulating adhesion means.

3. The solar generator according to claim 2, **characterised in that** each protective window of said intensification means (MI) is produced from a material that has dielectric properties different from those of the material from which at least some of said protective windows (FP) of said photoelectric cells (C) are produced.

4. The solar generator according to claim 2, **characterised in that** each protective window of said intensification means (MI) is produced from a protective material identical to the protective material from which the protective windows (FP) of said photoelectric cells (C) are produced, and **in that** the thickness of the protective material of each protective window of said intensification means (MI) is chosen to be strictly greater than the thickness of the protective material of the protective windows (FP) of said photoelectric cells (C).

5. The solar generator according to claim 2, **characterised in that** each protective window of said intensification means (MI) is produced from a protective material identical to the protective material from which the protective windows (FP) of said photoelectric cells (C) are produced, and **in that** the thickness of said adhesion means of each protective window of said intensification means (MI) is chosen to be strictly greater than the thickness of said adhesion means of the protective windows (FP) of said photoelectric cells (C).

6. The solar generator according to claim 2, **characterised in that** each protective window of said intensification means (MI) comprises an electrically floating metal left exposed to the void so as to form a triple point conducive to making an electrostatic discharge appear.

7. The solar generator according to any of claims 1 to 6, **characterised in that** it comprises a number of panels (Pi) each including a number of photoelectric cells and connected electrically to each other, and **in that** said intensification means (MI) are installed at at least one chosen location (EC) of at least one of said panels (Pi).

8. The solar generator according to claim 7, **characterised in that** said intensification means (MI) are installed at at least one chosen location (EC) situated on the panel (PI) intended to be the greatest distance away from a support structure (SE) of said equipment (EQ).

9. The solar generator according to any of claims 1 to 8, **characterised in that** said grounding line (LM) is coupled to measuring means (SM, MM) arranged to measure the intensities and/or durations and/or creation dates and/or creation frequencies of said discharge currents.

10. The solar generator according to any of claims 1 to 9, **characterised in that** it comprises insulating means arranged to insulate said grounding line (LM) electrically from the rest of said solar generator (GS).

11. The solar generator according to claim 10, **characterised in that** said insulation means are arranged to provide double insulation.

12. The solar generator according to any of claims 1 to 11, **characterised in that** said electrode (EL) is formed from a conductive plate comprising a central part (PC) and a peripheral part (PP) fastened to said intensification means (MI).

13. The solar generator according to any of claims 1 to 11, **characterised in that** said electrode (EL) is a photoelectric cell fastened to a rear face of said intensification means (MI) and electrically disconnected from the other photoelectric cells (C).

14. The solar generator according to any of claims 1 to 13, **characterised in that** said photoelectric cells (C) are produced from semiconductor material.

15. The solar generator according to claim 14, **characterised in that** the semiconductor material is "Gallium Arsenide" (GaAs).

16. The solar generator according to claim 15, **characterised in that** said photoelectric cells (C) are of the multi-junction type.

17. A spacecraft, **characterised in that** it comprises at least one solar generator (GS) according to any of the preceding claims.

18. The spacecraft according to claim 17, **characterised in that** it comprises a number of solar generators, at least one of which has no intensification means (MI) or discharging means (EL, LM).
